# EUROPEAN PATENT APPLICATION

(11) **EP 1 594 351 A2**
(43) Date of publication of application: **09.11.2005**
(21) Application number: 05009792.2
(22) Date of filing: 04.05.2005
(51) Int. Cl.: H05K 3/32, H05K 1/16, H01B 1/20, H01L 21/60

(54) **Compositions for use in electronics devices**

(30) Priority: 06.05.2004 US 840166
(71) Applicant: National Starch and Chemical Investment Holding Corporation, New Castle, Delaware 19720 (US)
(72) Inventor: McCormick, Demetrius, Belle Mead New Jersey 08502 (US); Nowicki, James W., Hopewell New Jersey 08525 (US); Cheng, Chih-Min, Westford Massachusetts 01886 (US); O'Hara, Wanda, Lawrence Massachusetts 01843 (US)
(74) Representative: Held, Stephan

(57) **Abstract**

A fast curing composition that comprises a polymeric resin, a conductive filler and one or more near-infrared absorbing additives and optionally an oxygen scavenger or corrosion inhibitor or both, and other additives such as reactive or nonreactive diluents, inert fillers, and adhesion promoters. The composition may be conductive, resistive or anisotropically conductive. In another embodiment, this invention is a method for improving the cure speed of a composition by exposing the composition to a near infrared energy source.

## Description

### FIELD OF THE INVENTION

This invention relates to methods of improving the curing speed of conductive, resistive and anisotropically conductive compositions for use in electronic devices and compositions that are suitable for use as fast curing conductive, resistive or anisotropically conductive compositions in electronic devices.

### BACKGROUND OF THE INVENTION

Conductive, resistive and anisotropically conductive compositions are used for a variety of purposes in the fabrication and assembly of semiconductor packages and electronic devices. For example, conductive adhesives are used to bond integrated circuit chips to substrates (die attach adhesives) or circuit assemblies to printed wire boards (surface mount conductive adhesives), and resistive materials are used to form planar or buried resistors in circuit boards. The cure time of the conductive adhesives is extremely important to manufacturers of electronic devices. The faster the cure time the more efficient the manufacturing process. Traditionally, conductive adhesives have been cured via thermal methods involving the application of heat to the device containing the uncured adhesive. The thermal curing process requires a significant investment in equipment, such as curing ovens, and a relatively long period of time. It would be particularly advantageous if a conductive adhesive could be cured faster and more efficiently than with the current thermal curing methods.

One aspect of the invention is directed to a process for bonding at least a first electronic component to a substrate, wherein at least a portion of at least one of the electrical components or the substrate has applied thereon a conductive adhesive: The adhesive may optionally contain a near infrared ("NIR") absorbing ingredient. The method comprises irradiating the applied adhesive with NIR radiant energy for a time sufficient to cure the adhesive, allowing the adhesive to solidify and thereby bonding the electrical component and the substrate together.

Another aspect of the invention is directed to a composition comprising an effective amount of a NIR absorbing ingredient such that upon exposure of the adhesive to short durations of radiant energy, the adhesive is quickly cured. The NIR absorbing ingredient selected for use may be dissolved and/or dispersed within the composition.

Still another aspect of the invention is directed to articles of manufacture comprising a composition such as a conductive adhesive that is capable of being cured via irradiation and optionally contains a NIR absorbing ingredient.

### SUMMARY OF THE INVENTION

The present invention comprises a method of increasing the curing speed of conductive, resistive and anisotropically conductive compositions, such as conductive adhesives, by the use of NIR curing. A further embodiment of the invention comprises a composition that contains an adhesive system, a conductive filler and one or more NIR absorbing ingredients and optionally an oxygen scavenger or corrosion inhibitor or both, reactive or nonreactive diluents, inert fillers, and adhesion promoters.

### DETAILED DESCRIPTION OF THE INVENTION

Chemical compositions containing resins, diluents, adhesion promoters, filler and other ingredients are used in the fabrication of electronic packages such as semiconductor packages, for example, as adhesives, encapsulants, or to form integral passives, such as resistors or capacitors. Such compositions can be cured quickly by the use of near infrared ("NIR") curing. As opposed to mid-infrared curing which is commonly performed in an infrared oven with wavelengths in the range of 5,000 - 30,000 nm, NIR curing is performed by exposure to an infrared wavelength in the range of about 700 - 5,000 nm. For many electronic applications, the curing of the adhesives should be such that the cured composition has a resistance of less than about 2 ohms. However, in certain electronic industrial applications higher resistance is acceptable. While conductive adhesives are described throughout the application, it is to be understood that the application includes other conductive, resistive and anisotropically conductive compositions, such as conductive ink. The compositions of the invention are generally resin-based, and may contain ingredients such as epoxy resin, epoxy/cyanate ester mixtures and acrylates. It has been discovered that the use of the NIR curing provides an unexpectedly quicker cure speed than curing via conventional thermal methods such as heating in an oven. Further, in certain instances the addition of one or more NIR absorbing additives to the formulation increases the cure speed when the adhesive is exposed to NIR curing. In those instances adhesive compositions of the invention that contain a NIR absorbing ingredient have increased absorption of NIR energy which facilitates faster heat transfer to the adhesive which optimizes cure speed performance. The adhesives of the invention reactivate on exposure to short durations of radiant energy and provide superior on-line performance and set speed that allows for quicker production speeds.

The adhesive compositions may be used for the bonding of electronic components to any substrate, such as circuit boards. Adhesive may be coated to either or both surfaces of a substrate and/or electronic component to be bonded. The substrate and component are commonly placed adjacent to each other prior to curing, with the adhesive between the two. If the substrate is transparent or translucent to the energy used for reactivation, the adhesive may be sandwiched between substrates first, and then NIR energy can be applied to initiate cure. If the substrate is not transparent to the energy, partial exposure by any portion of the adhesive will initiate cure of the adhesive.

Exemplary resins for use in these formulations are any of the resins currently used throughout the industry, such as vinyl, acrylic, phenolic, epoxy, maleimide, polyimide, or silicon-containing resins. The formulations and physical properties are known to those skilled in the art. In addition, cyanate ester may be combined with the epoxy or other resin.

Exemplary reactive diluents are glycidyl ethers, for example, 1,4-butanediol diglycidyl ether; vinyl ethers, for example, ethylene vinyl ether, and vinyl esters, for example, ethylene vinyl ester, and acrylates, for example, methyl methacrylate.

An exemplary nonreactive diluent is butyl carbitol.

Exemplary adhesion promoters are silanes and polyvinyl butyrol.

Oxygen scavengers may also be utilized in the composition. An oxygen scavenger is defined herein to be any chemical compound that will react with oxygen to prevent the oxygen from further reaction at the electrochemical cell cathode. Exemplary oxygen scavengers are hydroquinone, carbohydrazide, trihydroxybenzene, aminophenol, hydrazine, pyrogallol, carbohydrazone, polyethyleneamine, cyclohexanedione, hydroxylamine, methoxypropylamine, cyclohexylamine, diethylethanolamine, hydroxyalkylhydroxylamine, tetrasubstituted phenylenediamines, morpholinohexose reductone, keto-gluconates, amine bisulfites, lactone derivatives, phenol derivatives, and substituted quinolines.

To counteract the formation of metal oxide, corrosion inhibitors may be utilized. A corrosion inhibitor is defined herein to be any chemical compound that has a lone pair of electrons, such as nitrogen-, sulfur-, and oxygen-containing compounds, that will bind with metal and impede the reactivity of the metal at the electrochemical anode. Exemplary corrosion inhibitors are 1,10-phenathiodine, phenothiazine, benzotriazole, benzimidazole, mercaptobenzothiazole, dicyandiamide, 3-isoprolyamino-1-butyne, propargyl quinolinium bromide, 3-benzylamino-1-butyne, dipropargl ether, dipropargyl thioether, propargyl caproate, dianimoheptane, phenathroline, amine, diamine, triamine, hexamethyleneimide, decamethyleneimide, hexamethyleneiminebenzoate, hexamethyleneimine-3,5-dinitrobenzoate, hexamethylenetetramine, d-oximino-b-vinyl quinuclidine, aniline, 6-N-ethyl purine, 1-ethylamino-2-octadecylimidazoline, morpholine, ethanolamine, aminophenol, 8-hydroxyquinoline, pyridine and its derivatives, quinoline and its derivatives, acridine, imidazole and its derivatives, toluidine, mercaptan, thiophenol and its derivates, sulfide, sulfoxide, thiophosphate, and thiourea.

As will be recognized, some oxygen scavengers have corrosion inhibition capability, and some corrosion inhibitors have oxygen scavenger ability.

The filler utilized in the composition may vary depending upon the desired range of resistivity, conductivity, capacitance, or dielectric properties as needed for the specific circuit component. Providing the precise type and amount of filler for obtaining the electrical properties desired for a specific end use application is within the expertise of one skilled in the art. It will be understood that all resistors necessarily exhibit some conductance, and all conductors exhibit some resistance, and that resistors and conductors form a continuum of resistance and conductance depending on the specific property of the individual material. This continuum is also the case for dielectrics and capacitors. A dielectric may function as a true dielectric or isolating component, or as a capacitor, depending on the specific dielectric constant.

Exemplary conductive fillers are silver, copper, gold, palladium, platinum, carbon black, carbon fiber, graphite, aluminum, indium tin oxide, silver coated copper, silver coated aluminum, metallic coated glass spheres and antimony doped tin oxide. Exemplary inert fillers include talc, silica, silicate, aluminum nitride, and mica. Exemplary capacitance/dielectric fillers, which also will be deemed inert fillers herein, are ceramic, barium titanate, and titanium dioxide. In addition, conductive nanofillers, such as carbon nanotubes and/or non-conductive nanofillers, such as silicate, may also be utilized

The compositions may be cured via exposure to radiant NIR energy. Radiant NIR energy can be supplied by a number of sources, as will be apparent to the skilled practitioner. Examples include lasers, a high-pressure xenon arc lamp, a coiled tungsten wire, ceramic radiant heater and tungsten-halogen lamps. Preferred for use is radiant energy within the near NIR region. Both lamps and lasers are effective sources of NIR energy.

Peak NIR energy wavelengths of from 700nm to about 5,000nm may be used in the practice of the invention. Commercial sources of equipment capably of generating radiant NIR energy required for use in the practice of the invention include, but are not limited to, Research Inc. (Eden Prairie, MN), Chromalox (Ogden, UT), DRI (Clearwater, FL), Advent Electric Inc. (Bridgeport, PA), and Glo-Quartz Inc. (Mentor, OH).

The adhesive formulations of the invention may be applied in a continuous or discontinuous manner depending on surface area and coating weight desired. Particular patterns may be used to optimize substrate/adhesive contact. Depending on the adhesive, the bead size, thickness, distance apart and pattern will vary. The adhesive may be applied to the substrate by any method known in the art, and include, without limitation jet dispensing, roll coating, painting, dry-brushing, dip coating spraying, slot-coating, swirl spraying, printing (e.g., ink jet printing), flexographic, extrusion, atomized spraying, gravure (pattern wheel transfer) electrostatic, vapor deposition, fiberization and/or screen printing. The method of application to the substrate is not critical to the practice of the invention.

The cure efficiency, the ability of the adhesive to cure in a short period of time, will depend on the power of the energy source (e.g., lamp or laser), the distance of the energy source from the adhesive, the number of energy sources and the like, as will be apparent based on the disclosure herein. Cure time depends on receptivity of the adhesive, which depends on the coating weight or thickness of the adhesive and the energy flux density that the radiant source can supply to the adhesive (e.g., intensity per unit area). Energy flux density refers to the distance, focal point, power and intensity of the lamp or power source.

Preferably, the adhesives are formulated to cure upon exposure of less than about 1200 watts/sq inch of NIR energy, more preferably of less than about 800 watts/sq inch of NIR energy, for a period of less that about 10 seconds, more preferably less than about 5 seconds, even more preferably less than about 3 seconds. Preferred are thermoset adhesives which, when applied to a substrate, cure with a short duration of exposure to NIR energy, preferably less than about 10 seconds, more preferably less than about 2 seconds, even more preferably less than about 0.5 seconds.

It has been discovered that when a suitable NIR absorbing ingredient is added to ce rtain conventional adhesives, unexpectedly fast enhanced curing upon short duration of radiant energy can be achieved. While some traditional adhesives are primarily transparent to NIR, adhesives of the invention that contain epoxy and, optionally, cyanate ester and a NIR absorbing ingredient absorb and reflect the energy.

NIR absorbing ingredients include those dyes, pigments, fillers, polymers and resins or other ingredients that are capable of absorbing energy and providing an optimal balance of absorption, reflection, transmission and conduction. Examples include carbon black, graphite, Solvent Red (2',3-dimethyl-4-(2-hydroxy-naphthylazo)azo-benzene), Solvent Green, dyes such as Forest Green and Royal Blue masterbatch dye, commercially available from Clariant, cyanine-based dyes, oxides such as titanium dioxide, tetrakis)dialkylaminophenyl)aminium dyes, squarylium dyes, metal complexes, quinone, azo, radical multiphenylmethane, perylene, aromatic annulenes, fluorenylium and mixtures thereof. Such energy-absorbing ingredients possess various absorption characteristics. For example, halogen substituted 1,4,5,8-tetraanilioanthraquinones have excellent absorption in the vicinity of 860 nm and can absorb NIR in other ranges. Another example is squaraine, which is characterized by intense narrow absorption bands at relatively long wavelengths. Also specifically designed phthalocyanine compounds have been demonstrated exhibiting high transmittance to visible light and offering high efficient cut of near infrared.

Preferred NIR absorbing ingredients for use in the practice of the invention are broad and include NIR absorbers such as Epolight 1125 (Epolene, Inc), SDA6248 (H.W. Sands Corp.), SDA2072 (H.W. Sands Corp.) and carbon black. Carbon black can be manufactured by different methods such as the furnace black method, the gas (channel) black method, and the lamp black method. The key parameters affecting the radiant energy absorption of carbon black prepared by these various methods are average primary particle size, surface chemistry and aggregate structure. NIR absorbing ingredients for use in the practice of the invention will typically have an absorption in the range of from about 400nm to about 100,000nm, more preferably from about 700nm to about 10,000nm, even more preferably from about 700nm to about 5000nm.

The NIR absorbing ingredient may be added, with stirring, any time during the preparation of the base adhesive, or following preparation of the base adhesive. The amount added will depend on the type of additive the size and the dissolution or dispersion properties. The additive is added in an amount effective to cure the adhesive upon exposure to short durations (typically less than 2 seconds) of radiant energy. Typically, the additive will be present in an amount of about 0.001 to about 10 parts per 100 parts of the adhesive composition

Pigments, such as carbon black and graphite, are particulate in nature and will usually have somewhat of a spherical shape with average particle sizes in the range of about 0.01 to about 7 microns. Pigment particles aggregate, so aggregate size will be larger. The pigment aggregate size will preferably be smaller than about 500 microns. Aggregate sizes of less than about 100 microns are preferred, more preferably smaller than about 50 microns.

Suitable NIR absorbing ingredients for use in conductive adhesives of the invention may be identified by blending a desired adhesive with a chosen additive of various particle size and amount. Any conventional method of blending the NIR absorbing ingredient with the adhesive such as through use of a paddle mixer or high shear mixer such as Ross ME-100LC extruder, as would be apparent to the skilled practitioner, may be used to prepare the adhesive compositions of the invention. The starting adhesive and the adhesive containing the NIR absorbing ingredient then are compared by heating samples of each with a light from a radiant heat source. Suitable additives are those that exhibit acceptable bond strength and cure speed. Included in the practice of the invention are adhesives comprising absorber coated fillers and encapsulated absorbers.

The adhesive composition of this embodiment of the invention contains up to about 10 weight percent (but not 0%) of a energy-absorbing additive; about 10 to 90 weight percent of a resin; about 1 to 90 weight percent of a filler; optionally about 0 to 50 weight percent of a diluent; and about 0 to 80 weight percent of inert fillers.

In another embodiment, this invention is a method of enhancing the cure speed of a conductive or resistive composition comprising adding to the composition one or more near-infrared absorbing additives.

The invention is further illustrated by the following non-limiting examples.

### EXAMPLES

### Example 1.

Three different conductive adhesives were formed with resin and silver filler as shown in Table 1.

**Table 1.**

| Adhesive formulations | | | |
|---|---|---|---|
| Formulation | 1 (wt%) | 2 (wt%) | 3 (wt%) |
| Epoxy/Cyanate Ester Hybrid | 35 | -- | -- |
| Epoxy | -- | 20 | -- |
| Acrylate | -- | -- | 25 |
| Silver | 65 | 80 | 75 |

The cure time of each sample, with and without additives, was determined via curing in an infrared belt oven, the results of which are shown in Table 2.

**Table 2.**

| Cure of Adhesives with and without Additives | | | | | |
|---|---|---|---|---|---|
| Cure Temp (°C) | Cure Time (seconds) | Formulation 1 | Formulation 1 w/ 0.25 wt% carbon black | Formulation 1 w/ 1 wt% green dye | Formulation 3 |
| 73 | 4 | Not cured | | | |
| 120* | 2 | | Not cured | Partially cured | |
| 150 | 2 | Partially cured | Fully cured | Fully cured | |
| 150 | 4 | Fully cured | | | |
| 150 | 10 | | | | Partially cured |
| 150 | 20 | | | | Fully cured |
| 180 | 2 | | | | Not cured |

| | | | | | |
|---|---|---|---|---|---|
| *Curing performed on a hot plate | | | | | |

The NIR testing and resistance measurement was as follows: The adhesive samples where sandwiched between two polyethylene terephthalate (PET) substrates with the bottom substrate comprising silver ink pads linked in a daisy chain pattern and the top substrate comprising non-connected silver ink pads. The substrates were arranged in such a way that a top silver ink pad formed a bridge between connected ink pads on the bottom substrate. Each test sample contained a loop that consisted of 5 such bridges and the resistance was measured across these loops. The samples were approximately 1 by 1/16 inch in dimension. The samples were cured via NIR using a straight line cure method that allowed for the horizontal movement of the samples under the NIR lamp at effective line speeds of 10 to 350 feet per minute (equaling exposure times of 8 to 0.225 seconds). The measured cure temperatures ranged from 75 to 95 °C dependent on NIR lamp power. After curing, the loop resistance of each formulation was tested by microohmeter and the results are illustrated in Table 3, 4 and 5.

**Table 3.**

| Loop Resistance of Conductive Adhesives without Additives | | | | | |
|---|---|---|---|---|---|
| Cure Method | Cure Temp. (°C) | Cure Time (seconds) | Formulation 1 | Formulation 2 | Formulation 3 |
| Hot Plate | 110 | 10 | 1.7 - 1.8 | -- | 0.9 |
| Hot Plate | 125 | 120 | -- | 0.8 | -- |

Carbon black or NIR dye was added to the formulations and the samples were subjected to NIR curing using a 3200-watt lamp at 800 watts/sq. inch with varying sample exposure distances from the samples. The results for each formulation are shown in Tables 4A, 4B and 4C.

**Table 4A -**

| Loop Resistance and Cure Time for Formulation 1 | | | | | | | |
|---|---|---|---|---|---|---|---|
| Carbon Black (wt%) | -- | -- | -- | 0.25 | 0.25 | -- | -- |
| NIR Dye (wt%) | -- | -- | -- | -- | -- | 0.5 | 1.0 |
| Lamp Power (%) | 100 | 100 | 100 | 100 | 100 | 100 | 100 |
| Lamp Distance (in) | 8 | 8 | 8 | 8 | 8 | 8 | 8 |
| Cure Time (seconds) | 0.399 | 0.319 | 0.266 | 0.399 | 0.319 | 0.319 | 0.319 |
| Loop Resistance (ohm) | 1.2 - 1.5 | 3.8 - 4.0 | 4.4 | 1.2 - 1.3 | 2.0 - 2.7 | 1.2 - 1.6 | 1.4 - 1.6 |

**Table 4B -**

| Loop Resistance and Cure Time for Formulation 2 | | | | |
|---|---|---|---|---|
| Carbon Black (wt%) | -- | -- | 1.0 | -- |
| NIR Dye (wt%) | -- | -- | -- | 1.0 |
| Lamp Power | 30 | 60 | 60 | 60 |
| Lamp Distance (in) | 16 | 16 | 16 | 16 |
| Cure Time (seconds) | 5.32 | 1.12 | 1.12 | 1.12 |
| Loop Resistance (ohm) | 1.1 - 1.2 | 1.2 - 1.9 | 1.4 | 1.3 - 2.9 |

**Table 4C -**

| Loop Resistance and Cure Time for Formulation 3 | | | | | |
|---|---|---|---|---|---|
| Carbon Black (wt%) | -- | -- | -- | 0.25 | -- |
| NIR Dye (wt%.) | -- | -- | -- | -- | 1.0 |
| Lamp Power | 70 | 100 | 100 | 100 | 100 |
| Lamp Distance (in) | 16 | 8 | 8 | 8 | 8 |
| Cure Time (seconds) | 0.80 | 0.532 | 0.399 | 0.399 | 0.399 |
| Loop Resistance (ohm) | 1.1 | 1.3 | 6 | -- | -- |

As illustrated in Tables 2, 3 and 4A - 4C, the cure rate of the unmodified conductive adhesives is much faster upon exposure to NIR as opposed to curing via an infrared belt oven or hot plate. As shown in Tables 4A - 4C, the addition of an energy-absorbing additive provides different benefits to different adhesives. As illustrated in Table 4A, the addition of carbon black or green dye to an adhesive containing an epoxy/cyanate ester mix produces a fast cure time with desirable loop resistance levels. As shown in Table 4B, an epoxy-based adhesive produces similar resistance results with or without an additive. Finally, Table 4C shows that an acrylate-based adhesive produces fast curing without the addition of an energy-absorbing additive.

### Example 2.

Formulation 1 of Example 1 was cured in an infrared oven at various temperatures and exposure times. For the test, 0.25 weight percent carbon black was added to the samples and 1 weight percent green dye was added. The results are shown in Table 5.

**Table 5.**

| Resistance of Formulation 1 with Infrared Oven Cure | | | |
|---|---|---|---|
| Formulation | Temp (°C) | Cure Time (seconds) | Resistance (ohms) |
| 1 | 125 | 10 | 1.15² |
| 1 w/ green dye | 125 | 10 | 0.89³ |
| 1 w/ carbon black | 125 | 10 | 1.63² |
| 1 | 125 | 2 | No reading |
| 1 w/ green dye | 125 | 2 | 9 × 10⁶ |
| 1 w/ carbon black | 125 | 2 | No reading |
| 1 | 200 | 2 | 3.41² |
| 1 w/ green dye | 200 | 2 | 1.06³ |
| 1 w/ carbon black | 200 | 2 | 1.07² |
| 1 | 200 | 1.334 | 8.3² |
| 1 w/ green dye | 200 | 1.334 | 7⁵ |
| 1 w/ carbon black | 200 | 1.334 | 5.5⁴ |
| 1 | 200 | 0.667 | 30² |
| 1 w/ green dye | 200 | 0.667 | 33.6⁵ |
| 1 w/ carbon black | 200 | 0.667 | 29.2⁴ |

| | | | |
|---|---|---|---|
| ²Average of two tests | | | |
| ³Average of three tests | | | |
| ⁴Average of four tests | | | |
| ⁵Average of five tests | | | |

As shown in a comparison of Tables 4A - 4C and Table 5, the resistance values for the adhesives are improved via NIR curing as opposed to curing via infrared belt oven curing.

Many modifications and variations of this invention can be made without departing from its spirit and scope, as will be apparent to those skilled in the art. The specific embodiments described herein are offered by way of example only, and the invention is to be limited only by the terms of the appended claims, along with the full scope of equivalents to which such claims are entitled.

## Claims

1. A method of curing a composition for use with an electronic device comprising the steps of applying the composition to a substrate and subjecting the composition to a near infrared radiation source for a time sufficient to cure the composition.

2. The method of claim 1, wherein the composition is conductive, resistive or anisotropically conductive.

3. The method of claim 1, further comprising the step of adding a near infrared absorbing additive to the composition before the composition is applied to the substrate.

4. The method of claim 1, wherein the composition is exposed to a near infrared radiation source for less than about 10 seconds.

5. The method of claim 4, wherein the composition is exposed to a near infrared radiation -source for less than 2 seconds.

6. The method of claim 5, wherein the composition is exposed to a near infrared radiation source for less than 0.5 seconds.

7. The method of claim 1, wherein the composition is cured by exposure to near infrared radiation having a peak wavelength in the range of from about 700nm to about 5,000nm.

8. The method of claim 1, wherein the composition is cured for a sufficient time so that the resistance of the composition is less than about 2 ohms.

9. The method of claim 8, wherein the composition is cured for a sufficient time so that the resistance of the composition is less than about 1.5 ohms.

10. The method of claim 3, wherein the near infrared absorbing additive is selected from the group consisting of broad-band NIR absorbers, carbon black, graphite, Solvent Red (2',3-dimethyl-4-(2-hydroxy-naphthylazo)azo-benzene), Solvent Green, dyes, cyanine-based dyes, oxides, titanium dioxide, tetrakis(dialkylaminophenyl)aminium dyes, squarylium dyes, metal complexes, quinone, azo, radical multiphenylmethane, perylene, aromatic annulenes, fluorenylium, halogen substituted 1,4,5,8-tetraanilioanthraquinones, squaraine, phthalocyanine compounds and mixtures thereof.

11. A method of curing a composition for use with an electronic device comprising the steps of applying the composition to a substrate, placing an electronic component adjacent to the composition and subjecting the composition to a near infrared radiation source for a time sufficient to cure the composition.

12. The method of claim 11, wherein the composition is conductive, resistive or anisotropically conductive.

13. The method of claim 11, further comprising the step of adding a near infrared absorbing additive to the composition before the composition is applied to the substrate.

14. The method of claim 11, wherein the composition is exposed to a near infrared radiation source for less than about 10 seconds.

15. The method of claim 14, wherein the composition is exposed to a near infrared radiation source for less than 2 seconds.

16. The method of claim 15, wherein the composition is exposed to a near infrared radiation source for less than 0.5 seconds.

17. The composition of claim 11, wherein the composition is cured by exposure to near infrared radiation having a peak wavelength in the range of from about 700nm to about 5,000nm.

18. The method of claim 11, wherein the composition is cured for a sufficient time so that the resistance of the composition is less than about 2 ohms.

19. The method of claim 18, wherein the composition is cured for a sufficient time so that the resistance of the composition is less than about 1.5 ohms.

20. A composition for use in electronic devices comprising an effective amount of a near infrared absorbing ingredient to increase the cure speed of the composition upon exposure of the composition to near infrared radiation.

21. The composition of claim 20, wherein the composition is conductive, resistive or anisotropically conductive.

22. The composition of claim 20, wherein the composition comprises one or more resins and one or more fillers.

23. The composition of claim 22, wherein the one or more resins are selected from the group consisting of epoxy, cyanate ester, acrylates and mixtures thereof.

24. The composition of claim 23, wherein the one or more fillers are selected from the group consisting of silver, copper, gold, palladium, platinum, carbon black, carbon fiber, graphite, aluminum, indium tin oxide, silver coated copper, silver coated aluminum, metallic coated glass spheres, antimony doped tin oxide, talc, silica, silicate, aluminum nitride, mica, ceramic, barium titanate, titanium dioxide, nanofillers, silicate, carbon nanotubes, and mixtures thereof.

25. The composition of claim 20, further comprising one or more of the group consisting of corrosion inhibitors, diluents, oxygen scavengers, adhesion promoters or mixtures thereof.

26. The composition of claim 20, wherein the near infrared absorbing additive is selected from the group consisting of broad-band NIR absorbers, carbon black, graphite, Solvent Red (2',3-dimethyl-4-(2-hydroxy-naphthylazo)azo-benzene), Solvent Green, dyes, cyanine-based dyes, oxides,titanium dioxide, tetrakis)dialkylaminophenyl)aminium dyes, squarylium dyes, metal complexes, quinone, azo, radical multiphenylmethane, perylene, aromatic annulenes, fluorenylium, halogen substituted 1,4,5,8-tetraanilioanthraquinones, squaraine, phthalocyanine compounds and mixtures thereof.

27. The composition of claim 20, wherein the composition is curable upon exposure to near infrared radiation source for a time of less than ten seconds.

28. The composition of claim 27, wherein the composition is curable upon exposure to a near infrared radiation source for a time of less than two seconds.

29. The composition of claim 28, wherein the composition is curable upon exposure to a near infrared radiation source for a time of less than about 0.5 seconds.

30. The composition of claim 20, wherein the composition is capable of cure by exposure to near infrared radiation having a peak wavelength in the range of from about 700nm to about 5,000nm.

31. The composition of claim 20 which is capable of cure upon exposure of less than about 1200 watts/sq inch of near infrared energy for a period of less than about 10 seconds.

32. The composition of claim 31 which is capable of cure upon exposure of less than about 800 watts/sq inch of near infrared energy for a period of less than about 10 seconds.

33. The composition of claim 20 wherein the near infrared absorbing ingredient comprises an organic dye.

34. The composition of claim 20 wherein the near infrared absorbing ingredient comprises one or more pigments.

35. The composition of claim 34 wherein the pigment is carbon black.

36. The composition of claim 34 wherein the pigment is graphite.

37. The composition of claim 20, wherein the composition is a conductive adhesive.

38. A substrate comprising the composition of claim 19.

39. The substrate of claim 38 wherein the composition is applied to at least one predetermined location of the substrate by jet dispensing, roll coating, painting, dry-brushing, dip coating spraying, slot-coating, swirl spraying, printing, flexographic, extrusion, atomized spraying, fiberization, gravure, electrostatic, vapor deposition and/or screen printing.

40. The substrate of claim 38 wherein the composition is applied as a discontinuous coating.

41. The substrate of claim 38 wherein the composition is applied as a continuous coating.

42. The substrate of claim 38 which is an electronic circuit board.

43. An electronic device containing the composition of claim 20.
